(19)

Europäisches
Patentamt
European
Patent Office
Office européen
des brevets

(11) **EP 1 788 802 A1**

(12) **EUROPEAN PATENT APPLICATION**
published in accordance with Art. 158(3) EPC

(43) Date of publication:
**23.05.2007 Bulletin 2007/21**

(21) Application number: **05755738.1**

(22) Date of filing: **22.06.2005**

(51) Int Cl.:
*H04N 5/335* (2006.01)  *G06T 7/20* (2006.01)
*H01L 27/146* (2006.01)  *H04N 5/232* (2006.01)

(86) International application number:
**PCT/JP2005/011876**

(87) International publication number:
**WO 2006/022077 (02.03.2006 Gazette 2006/09)**

(84) Designated Contracting States:
**AT BE BG CH CY CZ DE DK EE ES FI FR GB GR HU IE IS IT LI LT LU MC NL PL PT RO SE SI SK TR**

(30) Priority: **23.08.2004 JP 2004241785**

(71) Applicant: SONY CORPORATION
**Minato-ku**
**Tokyo (JP)**

(72) Inventor: **MURAYAMA, Jun,**
**SONY CORPORATION**
**Tokyo,**
**108-0075 (JP)**

(74) Representative: **Tyson, Robin Edward**
**J.A. Kemp & Co.**
**14 South Square**
**Gray's Inn**
**GB-London WC1R 5JJ (GB)**

(54) **IMAGE PICKUP DEVICE, IMAGE PICKUP RESULT PROCESSING METHOD AND INTEGRATED CIRCUIT**

(57)  Motion information about individual pixels is obtained. A semiconductor chip 13 provided with an XY address controlled image pickup device, and a semiconductor chip 16 provided with a motion detection circuit 17 for obtaining motion information about the individual pixels are stacked.

# FIG.3

$$fy(x, y, t) = f(x, y, t) - f(x, y-1, t)$$

$$fx(x, y, t) = f(x, y, t) - f(x-1, y, t)$$

**Description**

TECHNICAL FIELD

The present invention relates to an imaging apparatus, an image processing method and an integrated circuit particularly suitable for obtaining information about motions provided by pixels. The present invention stacks a semiconductor chip provided with an XY address controlled image pickup device, and a semiconductor chip provided with a detection circuit for obtaining information about motions provided by pixels to process high-rate images with reliability by a motion detection process.

BACKGROUND ART

An imaging apparatus obtains an image through the raster scanning of a CCD (charge-coupled device) and carries out a process, such as a motion detection process.

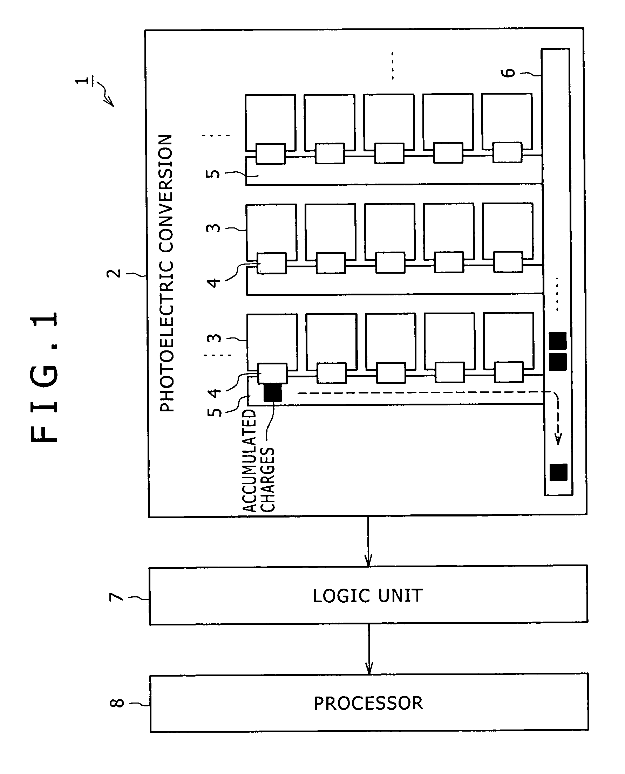

Fig. 1 is a block diagram of an imaging apparatus 1 provided with a CCD solid-state image pickup device 2. In the imaging apparatus 1, the CCD solid-state image pickup device 2 has pixels 3 of photoelectric sensors arranged in a matrix. Read gates 4 are controlled to transfer charges accumulated in frames of the pixels 3 to vertical transfer registers 5. In the CCD solid-state image pickup device 2, the accumulated charges are transferred sequentially from the vertical transfer registers 5 to a horizontal transfer resister 6 and the charges are sent out from the horizontal transfer register 6.

In the imaging apparatus 1, a logic unit 7 receives image signals provided by the CCD solid-state image pickup device 2 and processes the same by logical operations to obtain motion information from, for example, each pixel. A processor 8 processes the motion information, calculates motions of a specified area and uses the calculated motions for processing image signals.

Recently, CMOS solid-state image pickup devices have been practically used. A contrivance to integrate the CMOS solid-state image pickup device and peripheral circuits is proposed in, for example, JP-A-2004-31785.

When motion information about individual pixels is obtained, the logic unit 7 receives image signals for one frame and starts processing the image signals, and gives motion information about one frame in a batch to the processor 8.

For example, when image signals obtained by raster scanning is processed and CMOS solid-state image pickup devices are used to provide image signals at a high rate, a mot ion detect ion process delays and hence it is difficult to carry out processing the image signals at a high rate.

DISCLOSURE OF THE INVENTION

The present invention has been made in view of those problems and it is therefore an object of the present invention to provide an imaging apparatus capable of surely detecting and processing motions, an image signal processing method and an integrated circuit.

An imaging apparatus according to the present invention includes an integrated circuit formed by stacking a plurality of semiconductor chips, wherein the most upper semiconductor chip of the integrated circuit is provided with an image pickup device having pixels arranged in a matrix and controlled by XY address control to give image signals provided by the pixels to the lower semiconductor chip underlying the most upper semiconductor chip, and the lower semiconductor chip is provided with a motion detection circuit that carries out a process for processing the image signals provided by the image pickup device and obtaining motion information about the individual pixels, and a motion processing circuit that carries out a process for processing motion information about the individual pixels and provides the results of processing.

Since the most upper semiconductor chip of the integrated circuit is provided with the image pickup device having the pixels arranged in a matrix and controlled by XY address control to give image signals provided by the pixels to the lower semiconductor chip underlying the most upper semiconductor chip , the lower semiconductor chip is provided with the integrated circuit including a motion detection circuit that processes the image signals provided by the image pickup device and obtains motion information and the motion processing circuit that processes motion information about the individual pixels and provides the results of processing, for example, the motion detection circuit can process the image signals provided by the pixels of the image pickup device simultaneously in a parallel processing mode when the two semiconductor chips are connected. Thus the image signals can be surely processed by the motion detection process even if the image signals are provided at a high rate.

An image signal processing method according to the present invention of processing image signals provided by an imaging apparatus including an integrated circuit formed by stacking a plurality of semiconductor chips includes the steps of: controlling pixels arranged in a matrix on the most upper semiconductor chip of the integrated circuit by XY address control to give image signals provided by the pixels to the lower semiconductor chip underlying the most upper semiconductor chip; and processing the image signals provided by an image pickup device on the most upper semiconductor chip by the lower semiconductor chip underlying the most upper semiconductor chip to obtain motion information about individual pixels, to process the motion information about the individual pixels and to provide the results of processing.

The image signal processing method according to the present invention can surely process image signals obtained at a high rate by a motion detection process.

An integrated circuit according to the present invention includes a plurality of semiconductor chips stacked in layers; wherein the most upper semiconductor chip of the plurality of semiconductor chips is provided with an image pickup device having pixels arranged in a matrix and controlled by XY address control to give image signals provided by the pixels to the lower semiconductor chip underlying the most upper semiconductor chip, and the lower semiconductor chip is provided with a motion detection circuit that processes the image signals provided by the image pickup device and obtains motion information about the individual pixels and a motion processing circuit that processes the motion information about the individual pixels and provides the results of processing.

The integral circuit according provided at a high rate by a motion detection process.

An image signal processing method according to the present invention of processing image signals provided by an integrated circuit formed by stacking a plurality of semiconductor chips includes the steps of: controlling pixels arranged in a matrix on the most upper semiconductor chip of the integrated circuit by XY address control to give image signals provided by the pixels to the lower semiconductor chip underlying the most upper semiconductor chip; and processing the image signals provided by the pixels on the most upper semiconductor device serving as an image pickup device by the lower semiconductor chip underlying the most upper semiconductor chip to obtain motion information about individual pixels, to process the motion information about individual pixels and to provide the results of processing.

The image signal processing method according to the present invention can surely process image signals provided at a high rate by a motion detection process.

The present invention can surely process image signals by a motion detection process even if the image signals are provided at a high rate.

BRIEF DESCRIPTION OF THE DRAWINGS

Fig. 1 is a block diagram of a known imaging apparatus.
Fig. 2 is a block diagram of an imaging apparatus in a first embodiment according to the present invention.
Fig. 3 is an exploded perspective view of an integrated circuit included in the imaging apparatus shown in Fig. 2.
Fig. 4 is an exploded perspective view of a motion processing layer included in the integrated circuit shown in Fig. 3.
Fig. 5 is a diagram of data obtained by processing motion information.
Fig. 6 is a table showing output motion information.
Fig. 7 is a diagrammatic view of assistance in explaining an integrated circuit in a third embodiment according to the present invention.
Fig. 8 is a diagrammatic view of assistance in explaining a motion detection circuit included in the integrated circuit shown in Fig. 7.

BEST MODE FOR CARRYING OUT THE INVENTION

Preferred embodiments of the present invention will be described with reference to the accompanying drawings.

(1) First Embodiment

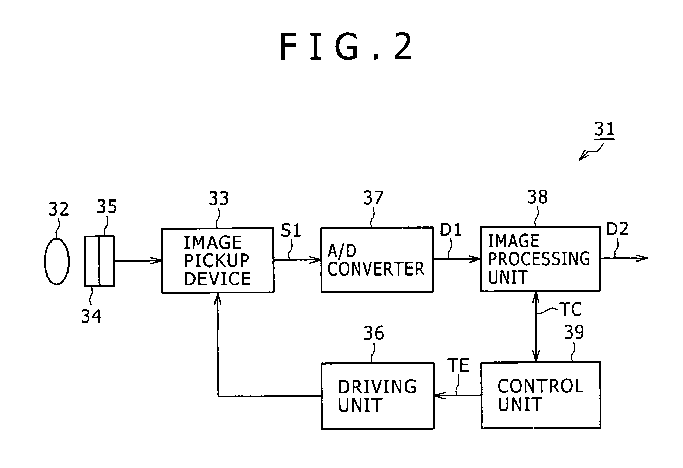

Fig. 2 is a block diagram of an imaging apparatus in a first embodiment according to the present invention. This imaging apparatus 31 compresses image data on a desired object and records the compressed image data on a recording medium and sends the image data to a desired device.

The imaging apparatus 31 is provided with a lens 32. A user operates the lens 32 to change magnification by zooming and adjusts an aperture stop. Incident light is focused on the image pickup surface of an image pickup device 33. An optical low-pass filter 34 attenuates components having high spatial frequencies among those of emergent light emergent from the lens 32. A color compensating filter 35 disposed behind the optical low-pass filter 34 compensates the color temperature of emergent light from the optical low-pass filter 34.

The image pickup device 33 is, for example, a CMOS solid-state image pickup device. The image pickup device 33 is operated by a timing signal provided by a driving unit 36 to convert an optical image formed on the image pickup surface by pixels into image signals S1 through photoelectric conversion.

The driving unit 36 is controlled by a control unit 39 and gives timing signals for timing operations of the image pickup device 33 to the image pickup device 33. Thus the control unit 9 controls operations of the image pickup device 33.

An analog-to-digital converter (A/D converter) 37 processes the image signals S1 by an analog-to-digital conversion process and provides image data D1.

An image processing unit 38 compresses the image data D1, gives coded data D2 obtained by compressing the image data D1 to a recording system and a transfer system. Thus the imaging apparatus 31 records the coded data D2 on a predetermined recording medium by the recording system and transfers the coded data D2 to an external device by the transfer system.

The control unit 39 includes a microcomputer serving as a data processing means. The control unit 39 carries out predetermined control programs and controls all the operations of the imaging apparatus 31 in response to instructions entered by the user by operating an operating device. In this embodiment, the control programs are installed in the imaging apparatus 31 beforehand. The control programs may be downloaded to the imaging apparatus from a network, such as the Internet, or from a recording medium. The recording medium may be any suitable one of recording mediums including optical disks, memory cards and such.

The control unit 39 starts operating upon the connection of the imaging apparatus 31 to a power supply by the user. The control unit 39 controls all operations in response to the operation of the operating device by the user to make the image pickup device 33 starts an image pickup operation and to start operations for recording and transferring image data provided by the image pickup device 33.

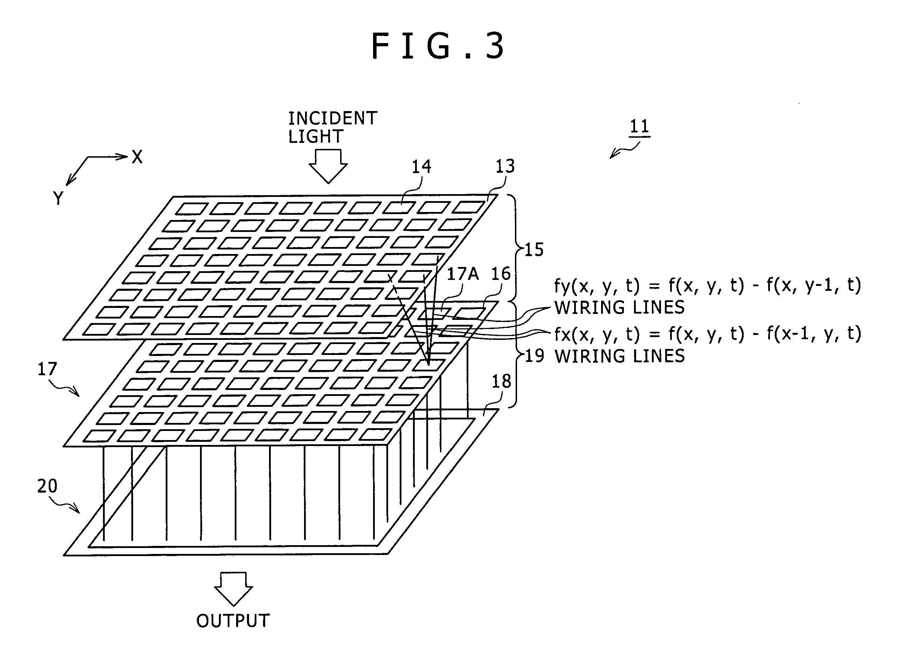

Fig. 3 is an exploded perspective view of an integrated circuit 11 included in the image pickup device 33 of the imaging apparatus 31. This integrated circuit 11 processes image signals in sequential steps and gives processed image signals to the processor. Circuit units that carryout steps of processes at stages are integrated in integrated circuits formed on thin semiconductor chips and the thin semiconductor chips are stacked sequentially in order of stages to form the integrated circuit 11. Thus the integrated circuit 11 is a stacked structure including processing layers respectively for carrying out the processes and interlayer wiring layers for connecting the processing layers. The most upper processing layer of the integrated circuit 11 serves as an image pickup layer 13 that provides image signals.

The image pickup layer 13 is a semiconductor chip provided with an integrated circuit including a solid-state image pickup device controlled by XY address control to provide image signals and a peripheral circuit connected to the solid-state image pickup device. The image pickup layer 13 has an image pickup surface formed by arranging pixels 14 in a matrix on its upper surface. Thus the image pickup device 33 mentioned in connection with Fig. 2 is formed. The peripheral circuit includes the driving circuit 36 for driving the pixels 14 and the A/D converter 37 for converting the image signals provided by the pixels 14 into image data, which are mentioned in connection with Fig. 2, and a read circuit for reading image signals from the pixels 14. The read circuit is driven by XY address control to read image data corresponding to image signals provided by the pixels 14 simultaneously in a parallel read mode at short intervals and gives the read image data through an interlayer connecting wiring layer 15 to the lower processing layers simultaneously in a parallel output mode.

The lower processing layer is a motion detection layer 16 for detecting motion information provided by the pixels of the image pickup layer 13. The motion detection layer 16 is provided with a motion detection circuit 17 for detecting motion information about individual pixels. In this embodiment, the motion detection circuit 17 includes a plurality of motion detectors 17A respectively corresponding to the pixels of the image pickup layer 13.

The interlayer wiring layer 15 transmits image data provided by each of the pixels of the image pickup layer 13 to the associated motion detector 17A of the motion detection layer 16 corresponding to the pixel and the adjacent motion detectors 17A respectively on the negative sides of the associated motion detector 17A with respect to an X-direction and a Y-direction, which enables the motion detection circuit 17 to detect motion information about individual pixels.

Suppose that the position of the associatedmotiondetector 17A has coordinates $(x, y)$ on a coordinate system defined by the X-axis parallel to the X-direction and the Y-axis parallel to the Y-direction. Then, an image signal $f(x, y)$ provided by the pixel 14 corresponding to the motion detector 17A and image signals $f(x-1, y)$ and $f(x, y-1)$ provided by the adjacent pixels 14 on the negative sides of the pixel 14 corresponding to the motion detector 17A with respect to the X-direction and the Y-direction are given to the motion detector 17A simultaneously in a parallel input mode. The motion detector 17A has a register for storing an image signal $f(x, y, t-1)$ provided by the associated pixel 14 in the preceding sampling cycle, and a subtraction circuit. The subtraction circuit carries out the following arithmetic operation based on subtraction circuits by using the image signal $f(x, y, t-1)$ stored in the register, an image signal $f(x, y, t)$ provided by the associated pixel 14, and image signals $f(x-1, y, t)$ and $f(x, y-1, t)$ provided by the adjacent associated pixels 14. And, the subtraction circuit calculates differences between the image signal provided by the associated pixel 14 and the image signals provided by the pixels adjacent to the associated pixel 14 with respect to the X-direction and the Y-direction, $f_x(x, y)$ and $f_y(x, y)$, and the difference on the time axis, $f_t(x, y)$, respectively.

$$f_x(x, y) = f(x, y, t) - f(x-1, y, t) \quad \ldots\ldots\ldots (1)$$

$$f_y(x, y) = f(x, y, t) - f(x, y-1, t) \quad \ldots\ldots\ldots (2)$$

$$f_t(x, y) = f(x, y, t) - f(x, y, t-1) \quad \ldots\ldots\ldots (3)$$

The motion detector 17A solve the following equations by an arithmetic circuit using the calculated differences $f_x(x, y)$, $f_y(x, y)$ and $f_t(x, y)$ to calculate motion information (u, v) about the associated pixel 14. In the following equations, $f_x(x-1, y)$ and $f_y(x-1, y)$ are calculated differences obtained by the adjacent motion detector 17 on the negative sides with respect to the X-direction and the Y-direction of the motion detector 17, and $f_t(x-1, y)$ is a calculated difference on the time axis.

$$f_x(x, y) * u + f_y(x, y) * v + f_t(x, y) = 0 \quad \ldots\ldots\ldots (4)$$

$$f_x(x-1, y) * u + f_y(x-1, y) * v + f_t(x-1, y) = 0 \quad \ldots (5)$$

The values U and v of the motion information (u, v) obtained by solving Equations (4) and (5) are represented by Expressions (6) and (7). In particular, the motion detector 17A calculates motion information (u, v) about the associated pixel 14 by carrying out the following arithmetic operation of Expressions (6) and (7) based on the arithmetic circuit.

$$u = K * \{ f_y(x-1, y) * f_t(x, y) - f_y(x, y) * f_t(x-1, y) \} \ldots (6)$$

$$v = K * \{ -f_x(x-1, y) * f_t(x, y) + f_x(x, y) * f_t(x-1, y) \ldots (7)$$

where K is expressed by Expression (8). When the denominator of Expression (8) is zero, the motion information (u, v) is set to (0, 0).

$$K = -1 / \{ f_x(x, y) * f_y(x-1, y) - f_y(x, y) * f_x(x-1, y) \} \ldots (8)$$

The motion detector 17A gives the thus obtained motion information (u, v) and the image data provided by the corresponding pixel 14 through an interlayer wiring layer 19 to a following processing layer which is a motion processing layer 18. In this way, the interlayer 19 underlying the motion detection layer 16 gives the motion information provided by the motion detector 17A of the motion detection layer 16 and the image data provided by each pixel 14 to the motion processing layer 18.

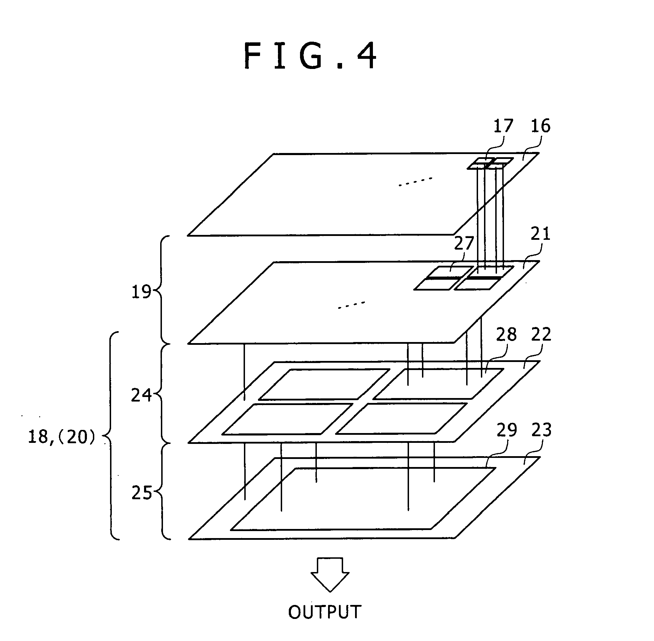

The motion processing layer 18 is provided with a motion processing circuit 20 for processing the motion information (u, v) calculated by the motion detection layer 16 about individual pixels to detect areas motions in which are identical. Themotion processing circuit 20 processes the motion information (u, v) in sequential steps. As shown in Fig. 4, the motion processing circuit 20 includes stacked semiconductor chips provided with integrated circuits for carrying out processes at the steps. Three processing layers 21 to 23 and two interlayer wiring layers 24 and 25 form the motion processing circuit 20.

Among these processing layers 21 to 23 of the motion processing circuit 20, the most upper processing layer 21 is assigned to a first motion uniformity deciding layer 21 provided with first motion uniformity deciding circuits 27.

The first motion uniformity deciding circuits 27 are provided for blocks each of a predetermined number of pixels arranged in the X-direction and the Y-direction, respectively. The motion detection layer 16 gives the motion information (u, v) about the pixels of the blocks corresponding to the first motion uniformity deciding circuits 27 and the image data to the first motion uniformity deciding circuits 27. The first motion uniformity deciding circuit 27 calculates the mean value of the motion information (u, v) about the pixels. The first motion uniformity deciding circuit 27 calculates the variance of the motion information (u, v) for each pixel 14 on the basis of the calculated mean and compares the calculated variance with a predetermined threshold. Thus the first motion uniformity deciding circuit 27 decides whether or not the motions represented by the motion information (u, v) about the pixels of the block corresponding to the first motion uniformity deciding circuit 27 belong to a single area. If the variance is not greater than the threshold and it is decided that the motions belong to the single area, the decision made on the basis of the threshold and the mean value of the motion information (u, v) about each pixel are sent out together with the image data provided by the pixels. If the variance is greater than the threshold and it is decided that the motions do not belong to the single area, the decision made on the basis of the threshold and the motion information (u, v) about the associated pixels are sent out together with the image data provided by the pixels.

The interlayer wiring layer 24 transmits output data provided by the first motion uniformity deciding layer 21 to a second motion uniformity deciding layer 22. The second motion uniformity deciding layer 22 is provided with second motion uniformity deciding circuits 28 each for a predetermined number of the first motion uniformity deciding circuits 27 of the first motion uniformity deciding layer 21.

The second motion uniformity deciding circuit 28 calculates the mean value of the mean values calculated by the first motion uniformity deciding circuits 27 and decided to belong to a single area, on the basis of the decisions made by the first motion uniformity deciding circuits 27. The second motion uniformity deciding circuit 28 calculates the variance of the mean values calculated by the first motion uniformity deciding circuits 27 on the basis of this mean value and compares the variance with a predetermined threshold. Thus the second motion uniformity deciding circuit 28 decides whether or not the pixels decided to belong to small areas by the first motion uniformity deciding circuits 27 belong to a large area larger than the small areas.

If the variance is not greater than the threshold and it is decided that the pixels belong to the large area, the second motion uniformity deciding circuit 28 provides the result of the decision made on the basis of the threshold and the mean value of the motion information (u, v) about the pixels together with image data provided by the pixels. If the variance is greater than the threshold and it is decided that the pixels do not belong to the large area, the decision made on the basis of the threshold and the mean values calculated by the first motion uniformity deciding circuits 27 are sent out together with the image data provided by the pixels. About the pixels which have been previously decided to be not belonging to the small area by the first motion uniformity deciding circuit 27, the motion information (u, v) provided by the first motion uniformity deciding layer 21 and the image data are sent out.

An interlayer wiring layer 25 transmits the output data provided by the second motion uniformity deciding layer 22 to a motion area deciding layer 23.

The motion area deciding layer 23 has one motion area deciding circuit 29. The motion area deciding circuit 29 calculates the mean value of the mean values of the motion information about the pixels respectively in the large areas calculated by the second motion uniformity deciding circuits 28 on the basis of decisions made by the second motion uniformity deciding circuits 28. The motion area deciding circuit 29 calculates the variance of the mean values calculated by the second motion uniformity deciding circuits 28 on the basis of the mean value and compares the variance with a threshold. Thus the motion area deciding layer 23 decides whether or not the pixels decided to belong to the same areas by the second motion uniformity deciding circuits 28 are included in single area extending on the entire surface of a picture.

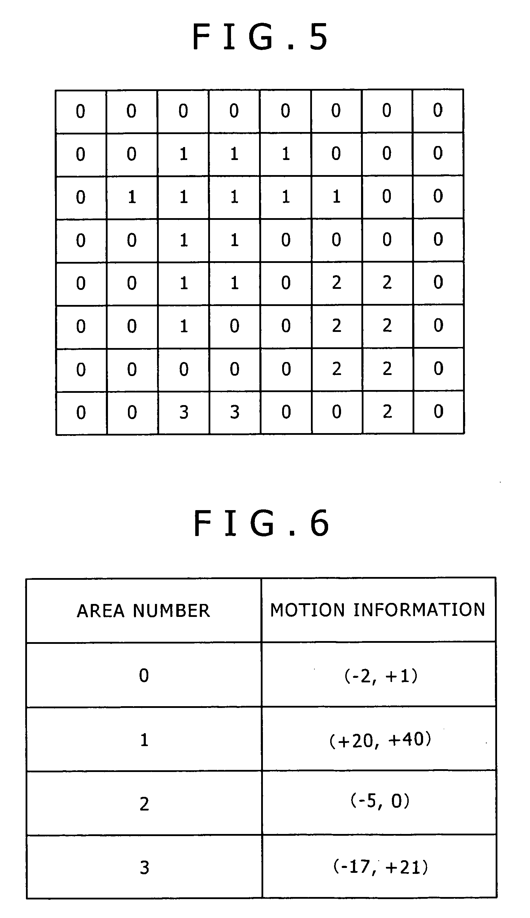

If the variance is not greater than the threshold and it is decided that the pixels belong to the single area on the picture, the motion area deciding circuit 29 assigns identification codes indicating the areas to the image data provided by the pixels belonging to the areas as shown in Fig. 5. In this case, those pixels are identified by an identification code 0 in Fig. 5. Even if the variation is not greater than the threshold, a decision is made as to whether or not the pixels which cannot readily be decided to belong to the area corresponding to the entire picture belong to other area on the basis of decisions made by the second motion uniformity deciding layer 22 and the first motion uniformity deciding layer 21 and the mean value. Similarly, identification codes indicting areas to which the image data belongs are assigned to the image data provided by the pixels. In Fig. 5, those pixels are identified by identification codes 1 and 2.

The motion area deciding circuit 29 gives the image data, to which the identification codes are assigned, in predetermined order to the processor. As shown in Fig. 6, the mean values of the motion information (u, v) about the pixels belonging to the areas are given together with the associated identification codes to the processor. Then, the motion processing circuit 20 calculates the mean values of the motion information (u, v) about the pixels in the small areas, the motion information (u, v) about the pixels in the large areas and the motion information (u, v) about the pixels in the entire picture, and detects areas expressing the same motions.

The processor of the imaging apparatus 31 in this embodiment processes the image data using the processing result provided by the motion area deciding circuit 29. Although the process for processing the image data is an image data coding process in this embodiment, the process may be an obj ect tracking process. In the integrated circuit 11, the configuration ranging from the interlayer wiring layer 16 to the processing layers forms the image processing unit 38 shown in Fig. 2.

(2) Operation of First Embodiment

The imaging apparatus shown in Figs. 2 and 3 forms an image of an obj ect on the image pickup surface of the integrated circuit 11 by the lens 32. The pixels 14 forming the image pickup surface provide image signals representing the optical image. The motion detection circuit 17 of the imaging apparatus processes the image signals provided by the pixels 14 to obtain motion information (u, v) about the pixels. The motion processing circuit 20 processes the motion information (u, v) about the pixels, calculates the mean values of the motion information (u, v) about the pixels in the small areas, the large areas and the entire picture and detects areas expressing the same motions .

The image pickup device that provides image data, the motion detection circuit 17 and the motion processing circuit 20 are formed in integrated circuits on thin semiconductor chips, and the thin semiconductor chips are stacked to form the integrated circuit 11 for carrying out those processes. The image signals provided by the pixels of the image pickup device are given simultaneously in a parallel transfer mode to the motion detection circuit 17 formed on the semiconductor chip underlying the image pickup device. The motion detection circuit 17 processes the image signals simultaneously in a parallel processing mode to provide the motion information (u, v) about the pixels. The motion information (u, v) about the pixels is given simultaneously in a parallel transfer mode to the motion processing circuit 20 formed on the semiconductor chip underlying the semiconductor chip on which the motion detection circuit 17 is formed. The motion processing circuit 20 processes the motion information about the pixels simultaneously in a parallel processing mode.

In the embodiment, the image signals provided by the pixels can be sent out and processed simultaneously in a parallel mode to obtain the motion information by using the stacked semiconductor chips respectively provided with the XY address controlled image pickup device and the motion detection circuit for detecting motion information about the pixels. Thus the motion detection process can use a sufficient processing time and can surely carry out the motion detection process even if the image signals are provided by the image pickup device at a high rate.

More concretely, the imaging apparatus in this embodiment processes the motion information (u, v) about the pixels thus obtained by the motion processing circuit, calculates the mean values of the motion information (u, v) about the pixels in the small areas, the large areas and the entire picture and detects areas expressing the same motions. Processes including a motion compensation process can be carried out by effectively using the thus obtained motion information (u, v) about the pixels.

The integrated circuit 11 calculates the mean values of the motion information (u, v) in sequential steps in order of the small areas, the large areas and the entire picture by the motion processing circuit 20 for processing the motion information (u, v) to determines the areas expressing the same motions. As shown in Fig. 4, the motion processing circuit 20 is built by stacking the semiconductor chips provided with the integrated circuits for carrying out processes for the small areas, the large areas and the entire picture. The motion information can be processed at a high rate by simultaneously transferring data processed by the integrated circuit on the semiconductor chip in a parallel transfer mode to the integrated circuit formed on the semiconductor chip underlying the former semiconductor chip. Thus the image signals are provided at a high rate to detect motions and the thus obtained motion information can be surely processed.

(3) Effect of First Embodiment

The motion detection process can be surely carried out, even if the image signals are provided at a high rate, by using the stacked semiconductor chips respectively provided with the XY address controlled image pickup device and the motion detection circuit for detecting motion information about the pixels.

The thus obtained motion information can be effectively used by calculating the mean values of the motion information about the pixels with the motion processing circuit for processing the motion information and detecting the areas expressing the same motions.

(4) Second Embodiment

In the second embodiment, the motion processing circuit 20 mentioned above in connection with Fig. 3 calculates the sum of interframe differences in motion information (u, v) about the pixels and gives the calculated sum to a processor. An integrated circuit 11 included in the second embodiment is identical with the integrated circuit 11 included in the first embodiment, except that the motion processing circuit 20 of the second embodiment is different from that of the first embodiment. The sum of the interframe differences is the sum of squares of the differences or the sum of the absolute values of the differences.

In the second embodiment, a semiconductor chip provided with a an XY address controlled image pickup device and a semiconductor chip provided with a motion detection circuit for detecting motion information about individual pixels are stacked. Thus even image signals provided at high rate can be surely processed by a motion detection process, and the sum of interframe differences in the motion information about individual pixels is calculated to use the detected motion information effectively.

(5) Third Embodiment

The interlayer wiring layer 15 of the integrated circuit 11 included in the first embodiment needs three wiring systems for each of pixels 14 to receive an image signal provided by the pixel 14 and image signals provided by the pixels 14 on the negative sides of the pixel 14 with respect to the X-direction and the Y-direction. Therefore, the layout of the wiring lines of the interlayer wiring layer 15 is complicated, the interlayer wiring layer 15 needs complicated manufacturing processes and the yield of a manufacturing line for manufacturing the interlayer wiring layer 15 is low.

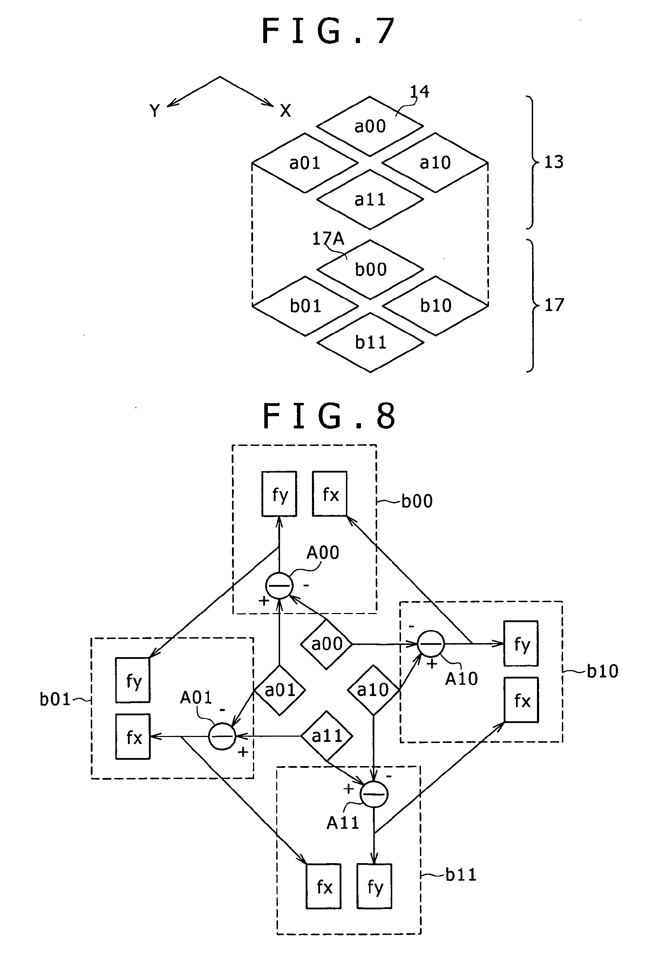

In the third embodiment, a motion detector 17A is shared by the adjacent pixels. As shown in Fig. 7, four pixels 14 adjacent to each other with respect to the X-direction and the Y-direction are designated by a00 to a11, and motion detectors 17A corresponding to the pixels a00 to a11 are designated by b00 to b11, respectively. The sign of the difference $f_x$ between the pixel a00 nearest to the origin of the X-direction and the Y-direction and the pixel a10 adj acent to the pixel 00 with respect to the X-direction expressed by Expression (1) is reversed to obtain a difference $f_x$ expressed by Expression (1) between the pixel a10 and the adjacent pixel a00 on the negative side of the pixel a10 with respect to the X-direction. The sign of the difference $f_y$ between the pixel a00 nearest to the origin of the X-direction and the Y-direction and the pixel a10 adjacent to the pixel 00 with respect to the Y-direction expressed by Expression (2) is reversed to obtain a difference $f_y$ expressed by Expression (2) between the pixel a10 and the adjacent pixel a00 on the negative side of the pixel a10 with respect to the Y-direction.

The motion detector 17A (b00 to b11) uses this relation. As shown in Fig. 8, each of subtraction circuits A00 to A11 calculates a difference $f_x$ or $f_y$ between the pixel and one of the adjacent pixels, gives the calculated difference $f_x$ or $f_y$ to the motion detector 17A (b00 to b11) associated with the one of the adjacent pixels, and each of the motion detectors 17A (b00 to b11) calculates a difference $f_x$ with respect to the X-direction and a difference $f_y$ with respect to the Y-direction. Motion information (u, v) is calculated by processing the difference $f_x$ with respect to the X-direction and the difference $f_y$ with respect to the Y-direction thus obtained.

A motion detection circuit 17 determines motion information (u, v) about individual pixels by processing the differences in image signal between the adjacent pixels by an arithmetic process. The subtraction circuit for calculating the differences is shared by the adjacent pixels. Consequently, the configuration of the motion detection circuit 17 is simplified accordingly and the layout of the wiring lines of the interlayer wiring layer 15 is simplified. Practically, only two wiring lines need to be connected to each motion detector 17A when the subtraction circuit is thus shared by the pixels and hence the interlayer wiring layer 15 can be simplified and yield can be improved.

In the third embodiment, the semiconductor chip provided with the XY address controlled image pickup device and the semiconductor chip provided with the motion detection circuit for obtaining motion information about individual pixels are stacked and the subtraction circuit for calculating the difference is shared by the adjacent pixels. Thus the motion detection process can be surely carried out even if the image signals are provided at a high rate and the whole construction is simplified.

(6) Other Embodiments

Although the motion detectors of the third embodiment are provided with the subtraction circuits, respectively, one of the motion detectors associated with the adjacent pixels may be provided with a subtraction circuit, which further simplified the interlayer wiring layer.

Although the motion detection circuit is formed by the chip other than the motion detection circuit and the motion processing circuit is formed by stacking the plurality of semiconductor chips in the foregoing embodiment, those may be formed on a single semiconductor chip. In short, the stacked structure formed by stacking the semiconductor chip provided with the image pickup device and the semiconductor chip provided with the motion detection circuit can surely carry out the motion detection process even if the image signals are provided at a high rate.

Although the integrated circuit of the foregoing embodiment provides also the image data, the integrated circuit can be used widely for providing only the result of motion processing when necessary.

Although the foregoing embodiments have been described as applied to the coding process and the obj ect tracking process, the present invention is applicable widely to various imaging apparatuses that use motion information.

INDUSTRIAL APPLICABILITY

The present invention is applicable to detecting motion information about individual pixels.

**Claims**

1. An imaging apparatus comprising an integrated circuit formed by stacking a plurality of semiconductor chips, wherein the most upper semiconductor chip of the integrated circuit is provided with an image pickup device having pixels arranged in a matrix and controlled by XY address control to give image signals provided by the pixels to the lower semiconductor chip underlying the most upper semiconductor chip, and
the lower semiconductor chip is provided with a motion detection circuit that carries out a process for processing the image signals provided by the image pickup device and obtaining motion information about the individual pixels, and a motion processing circuit that carries out a process for processing motion information about the individual pixels and provides the results of processing.

2. The imaging apparatus according to claim 1, wherein the process to be carried out by the motion processing circuit for processing the motion information about the individual pixels is a process for averaging the motion information about the individual pixels.

3. The imaging apparatus according to claim 1, wherein the process to be carried out by the motion processing circuit for processing the motion information about the individual pixels is a calculation process for calculating the sum of interframe differences in the motion information about the individual pixels.

4. The imaging apparatus according to claim 1, wherein the process to be carried out by the motion processing circuit for processing the motion information about the individual pixels is a process for processing the motion information about the individual pixels in sequential steps to detect areas expressing the same motion.

5. The imaging apparatus according to claim 1, wherein the motion detection circuit obtains the motion information about the individual pixels by processing differences in image signal between the adjacent pixels calculated by subtraction, and a subtraction circuit for calculating the differences is shared by the adjacent pixels.

6. An image signal processing method of processing image signals provided by an imaging apparatus including an integrated circuit formed by stacking a plurality of semiconductor chips, said image signal processing method comprising the steps of:

controlling pixels arranged in a matrix on the most upper semiconductor chip of the integrated circuit by XY address control to give image signals provided by the pixels to the lower semiconductor chip underlying the most upper semiconductor chip; and
processing the image signals provided by an image pickup device on the most upper semiconductor chip by the lower semiconductor chip underlying the most upper semiconductor chip to obtain motion information about individual pixels, to process the motion information about the individual pixels and to provide the results of processing.

7. An integrated circuit comprising a plurality of semiconductor chips stacked in layers;
wherein the most upper semiconductor chip of the plurality of semiconductor chips is provided with an image pickup device having pixels arranged in a matrix and controlled by XY address control to give image signals provided by the pixels to the lower semiconductor chip underlying the most upper semiconductor chip, and
the lower semiconductor chip is provided with a motion detection circuit that processes the image signals provided by the image pickup device and obtains motion information about the individual pixels and a motion processing circuit that processes the motion information about the individual pixels and provides the results of processing.

8. An image signal processing method of processing image signals provided by an integrated circuit formed by stacking a plurality of semiconductor chips, said image signal processing method comprising the steps of:

controlling pixels arranged in a matrix on the most upper semiconductor chip of the integrated circuit by XY address control to give image signals provided by the pixels to the lower semiconductor chip underlying the most upper semiconductor chip; and

processing the image signals provided by the pixels on the most upper semiconductor device serving as an image pickup device by the lower semiconductor chip underlying the most upper semiconductor chip to obtainmotion information about individual pixels, to process the motion information about individual pixels and to provide the results of processing.

# FIG.1

EP 1 788 802 A1

# F I G . 2

# FIG.3

INCIDENT
LIGHT

11

$$fy(x, y, t) = f(x, y, t) - f(x, y-1, t)$$
WIRING LINES

$$fx(x, y, t) = f(x, y, t) - f(x-1, y, t)$$
WIRING LINES

OUTPUT

EP 1 788 802 A1

# FIG.4

OUTPUT

EP 1 788 802 A1

# FIG.5

| 0 | 0 | 0 | 0 | 0 | 0 | 0 | 0 |
|---|---|---|---|---|---|---|---|
| 0 | 0 | 1 | 1 | 1 | 0 | 0 | 0 |
| 0 | 1 | 1 | 1 | 1 | 1 | 0 | 0 |
| 0 | 0 | 1 | 1 | 0 | 0 | 0 | 0 |
| 0 | 0 | 1 | 1 | 0 | 2 | 2 | 0 |
| 0 | 0 | 1 | 0 | 0 | 2 | 2 | 0 |
| 0 | 0 | 0 | 0 | 0 | 2 | 2 | 0 |
| 0 | 0 | 3 | 3 | 0 | 0 | 2 | 0 |

# FIG.6

| AREA NUMBER | MOTION INFORMATION |
|---|---|
| 0 | (-2, +1) |
| 1 | (+20, +40) |
| 2 | (-5, 0) |
| 3 | (-17, +21) |

# FIG.7

# FIG.8

## INTERNATIONAL SEARCH REPORT

| | International application No. |
|---|---|
| | PCT/JP2005/011876 |

A. CLASSIFICATION OF SUBJECT MATTER
Int.Cl⁷ H04N5/335, G06T7/20, H01L27/146, H04N5/232

According to International Patent Classification (IPC) or to both national classification and IPC

B. FIELDS SEARCHED

Minimum documentation searched (classification system followed by classification symbols)
Int.Cl⁷ H04N5/335, G06T7/20, H01L27/146, H04N5/232

Documentation searched other than minimum documentation to the extent that such documents are included in the fields searched
Jitsuyo Shinan Koho        1922-1996   Jitsuyo Shinan Toroku Koho   1996-2005
Kokai Jitsuyo Shinan Koho  1971-2005   Toroku Jitsuyo Shinan Koho   1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2001-94888 A (Canon Inc.),<br>06 April, 2001 (06.04.01),<br>Full text; Figs. 1 to 11<br>(Family: none) | 1,2,6-8<br>3,4<br>5 |
| X | JP 63-174356 A (Director General, Agency of Industrial Science and Technology),<br>18 July, 1988 (18.07.88),<br>Full text; Figs. 1 to 4<br>& WO 1988/003590 A1 | 1 |
| Y | JP 2003-78829 A (Japan Science and Technology Corp.),<br>14 March, 2003 (14.03.03),<br>Par. Nos. [0007] to [0045]; Figs. 1 to 23<br>& WO 2003/023712 A1    & EP 1435588 A1 | 3 |

| ☒ Further documents are listed in the continuation of Box C. | ☐ See patent family annex. |
|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>21 September, 2005 (21.09.05) | Date of mailing of the international search report<br>11 October, 2005 (11.10.05) |
|---|---|
| Name and mailing address of the ISA/<br>Japanese Patent Office | Authorized officer |
| Facsimile No. | Telephone No. |

Form PCT/ISA/210 (second sheet) (January 2004)

<table>
<tr><td colspan="2">**INTERNATIONAL SEARCH REPORT**</td><td>International application No.<br>PCT/JP2005/011876</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 7-262381 A  (RCA Thomson Licensing Corp.),<br>13 October, 1995 (13.10.95),<br>Par. Nos. [0001] to [0038]; Figs. 1 to 7<br>& US 5742710 A | 4 |
| Y | JP 2-238580 A  (Nippon Telegraph And Telephone Corp.),<br>20 September, 1990 (20.09.90),<br>Full text; Figs. 1 to 2<br>(Family: none) | 4 |
| A | JP 2001-128067 A  (Director General of National Institute of Advanced Industrial Science and Technology),<br>11 May, 2001 (11.05.01),<br>Full text; Figs. 1 to 10<br>(Family: none) | 1-8 |
| A | JP 2001-184498 A  (Kabushiki Kaisha Ecchandesu),<br>06 July, 2001 (06.07.01),<br>Full text; Figs. 1 to 36<br>& WO 2001/041448 A1     & EP 1248465 A1 | 1-8 |
| A | JP 2000-299820 A  (Hamamatsu Photonics Kabushiki Kaisha),<br>24 October, 2000 (24.10.00),<br>Full text; Figs. 1 to 6<br>(Family: none) | 1-8 |
| A | JP 8-54283 A  (Nippon Telegraph And Telephone Corp.),<br>27 February, 1996 (27.02.96),<br>Full text; Figs. 1 to 7<br>(Family: none) | 1-8 |
| A | JP 58-92260 A  (Mitsubishi Electric Corp.),<br>01 June, 1983 (01.06.83),<br>Full text; Fig. 1<br>(Family: none) | 1-8 |
| A | JP 5-268535 A  (Toshiba Corp.),<br>15 October, 1993 (15.10.93),<br>Full text; Figs. 1 to 9<br>(Family: none) | 1-8 |
| A | JP 3-101385 A  (Olympus Optical Co., Ltd.),<br>26 April, 1991 (26.04.91),<br>Full text; Figs. 1 to 10<br>& US 5055930 A | 1-8 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004031785 A